# EUROPEAN PATENT APPLICATION

(11) **EP 2 244 343 A1**
(43) Date of publication of application: **27.10.2010**
(21) Application number: 09305348.6
(22) Date of filing: 23.04.2009
(51) Int. Cl.: H01S 5/50

(54) **System, device and method for optical amplification**

(71) Applicant: Alcatel Lucent, 75008 Paris (FR)
(72) Inventor: Brenot, Romain, 91460, MARCOUSSIS (FR); Kazmierski, Christophe, 91460, MARCOUSSIS (FR); Garreau, Alexandre, 91460, MARCOUSSIS (FR)
(74) Representative: Shamsaei Far, Hassan

(57) **Abstract**

Optical amplification using a photonic integrated circuit device comprising a gain-clamped semiconductor optical amplifier, GCSOA, having a clamping wavelength and at least one data modulation section having an operating wavelength. The photonic integrated circuit device further comprises an optical filter section provided between the GCSOA and the data modulation section and configured for filtering a clamping wavelength generated by the GCSOA.

## Description

The present invention relates to optical components for optical communications.

### BACKGROUND

Photonic integrated circuits can significantly reduce the size and cost of packaged components for optical communications. Moreover, such components are also used in order to increase the modulation speed. The integration technology used for manufacturing such components requires passive connections by means of splitters or guides which are located between active functions. This requirement leads to intrinsic propagation losses which reduce, in turn, the optical output power.

### SUMMARY

It is known that continuous wave (CW) emitting photonic devices, such as DBR-SOA (distributed Bragg reflector - semiconductor optical amplifier), allow for the integration of semiconductor optical amplifiers (SOA) in order to compensate for losses and to amplify the output power to a desired level (typically 10mW or higher). However, severe limitations may appear in modulated data sources when a simple SOA is used as amplifier because the SOAs typically add a significant chirp to the signal due to large phase-amplitude coupling. This problem is particularly important above 10Gb/s as the chirp limited distance may be far below 40km limiting application fields. The reason for this is that the maximum transmission distance limited by fiber group velocity dispersion is a function of the inverse square of the bit rate. For example if a propagation distance of 40km is available for 10Gb/s bit rate, the propagation distance for a 40Gb/s rate would be reduced to 40/16km, namely 2.5km. Semiconductor Optical Amplifiers (SOAs) can be integrated in an integrated circuit and do amplify in any of the typical telecommunication spectrum bands (such as for example, O, E, S, C, L, U, *i.e.* from 1260nm to 1675nm, however they induce non-linearities (such as chirp, crosstalk, etc...) when they operate so as to output high power.

In the following, the term chirp-free is to be understood to comprise complete absence of chirp or a presence of chirp at a substantial low value such that its presence may be considered negligible. Typically, a distinction may be made between inherent chirp due to phase-amplitude coupling in any matter, sometimes associated to dynamic chirp and excess chirp due to additional effects such as presence of modulated carriers. Therefore the determination of what may be considered negligible may vary from case to case, nevertheless such determination may be performed by a person with ordinary skill in the art. One known solution to the problem of the presence of chirp is to use amplification with a non-integrable external EDFA (the term non-integrable is to be understood to refer to an element which cannot be manufactured together with InP-photonic devices as a single component). However, such solution involves incurring in high manufacturing cost, thus making it prohibitive as regard many applications such as for example in access networks, for example.

On the other hand, the so-called gain-clamped SOAs (GCSOAs) have shown chirp-free amplification of data signals on wavelengths different from their own emission. The physical basis for obtaining low-chirp or chirp free amplification in GCSOAs is due to the clamping of the carrier concentration generated due to the laser effect. Therefore, spurious carrier modulation - which in a conventional SOA leads to optical index modulation and thereby to excess of chirp - is strongly limited in a GCSOA. One example of a GCSOA may be a DFB (distributed feedback) lasers in which carrier concentration is clamped above a threshold. GCSOAs have been commonly used as external amplifiers in which spurious DFB emission is blocked by an optical isolator. However, this solution is also costly (e.g. costs related to packaging) and furthermore, it dose not solve the problem of providing a chirp-free amplification in the case of using reflective modulators which are increasingly emerging in the market. Furthermore, the integration of GCSOAs in data-source components in a cost effective manner is considered a very difficult or even undesirable task because the DFB wavelength emitted by these devices "blinds" or perturbs data modulators or any active function in the integrated photonic devices.

The term "blind" in the present context refers to an effect where an incoming emission is absorbed by the modulation source such that it inhibits the normal operation of the device for example by saturating -no longer sensitive to driving signal - modulation effects)

Another possible solution is the use of erbium-doped fiber amplifier (EDFA) which is a suitable high-power and chirp-free amplifier. However EDFAs cannot be integrated with a modulated source as they typically involve different materials and technologies, EDFA relating to fiber technology and modulated sources relating typically to InP photonics. Furthermore, for telecommunications applications, their amplification range is limited as they do not amplify outside the C-band (1530nm-1560nm).

The inventors have attempted to address the problem related to the difficulties associated to the integration of an optical amplifier into an integrated circuit such that the amplification is chirp-free.

According to some embodiments, there is provided a photonic integrated circuit device comprising a gain-clamped semiconductor optical amplifier, GCSOA, having at least one clamping wavelength and at least one data modulation section having an operating wavelength, wherein the photonic integrated circuit further comprises an optical filter section provided between the GCSOA and the data modulation section and configured for filtering a clamping wavelength generated by the GCSOA.

In some specific embodiments, the optical filter section comprises a part of the data modulation section biased under a reverse-bias voltage.

In some other specific embodiments, the optical filter section comprises a wavelength optical filter such as an arrayed waveguide grating or a wavelength selective coupler or a wavelength selective filter.

In some other specific embodiments the optical filter section comprises a part of the data modulation section biased under a reverse-bias voltage and a wavelength optical filter.

According to some embodiments, the photonic integrated circuit device is operable in emission mode.

According to some embodiments, the photonic integrated circuit device is operable in reflection mode.

According to some embodiments, there is provided a method of amplifying an optical signal having an operating wavelength, wherein the operating wavelength is modulated by a data modulation section and amplified by a gain-clamped semiconductor optical amplifier, GCSOA, the data modulation section and the GCSOA being integrated into a photonic integrated circuit device, the method further comprising:
- filtering, by an optical filter section, a clamping wavelength generated by the GCSOA.

In some specific embodiments, the lasing or clamping wavelength of the GCSOA is selected to be out of the operating spectrum of the data modulation section.

In some further specific embodiments, the spectral difference between the clamping wavelength and the wavelengths to be emitted in the case of C or L band is above 50nm.

According to some embodiments, there is provided an optical network element comprising the photonic integrated circuit device of the embodiments described herein.

According to further embodiments, there is provided an access network comprising the network element described herein.

These and further features and advantages of the present invention are described in more detail in the following description as well as in the claims with the aid of the accompanying drawings.

### BRIEF DESCRIPTION OF THE DRAWINGS

Figure 1 is an exemplary schematic representation of a photonic device structure with a modulation section and an amplifying section situated adjacent to each other.
Figure 2 is an exemplary schematic representation of a photonic device having a structure in accordance with an embodiment of the invention.
Figure 3 is an exemplary schematic representation of a photonic device having a structure in accordance with another embodiment of the invention.
Figure 4 is an exemplary schematic representation of a photonic device having a structure in accordance with a further embodiment of the invention

### DETAILED DESCRIPTION

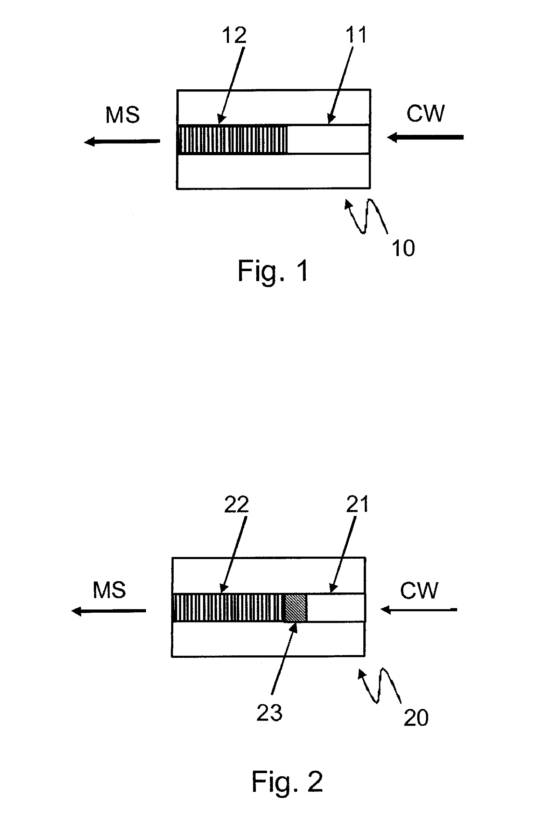

Before the embodiments of the invention are described, a brief description is provided herein in relation to a device having a a modulation section and an amplifying section situated adjacent to each other with reference to figure 1,

In figure 1, the photonic device 10 is shown to have a modulation section 11 and an amplifying section 12. In this representation the device is assumed to be operable in emission mode such as a laser source, an Electro-absorption Modulated Laser (EML), or a laser-Mach Zehnder Modulator. The modulation section may comprise any known modulation source and the amplifying section 12 is made of a GCSOA. A continuous wave signal entering into the device is shown by means of arrow CW. The input signal CW is modulated in the modulation section 11 and next amplified by the amplifying section 12. The modulated and amplified signal is then emitted from the device as shown by means of arrow MS.

However a device made based on a structure as described above would present drawbacks because the GCSOA 12 generates a back emission of light towards the modulation section 11 with a substantially high intensity that either completely blinds or at least perturbs the operation of the modulation source.

Figure 2 is an exemplary schematic representation of a photonic device according to an embodiment. The device 20 has a modulation section 21 and an amplifying section 22. In this representation, in similar fashion as in figure 1, the device is assumed to be operable in emission mode.

The modulation section comprises any known modulation source 21 and the amplifying section 22 is made of a GCSOA. A continuous wave signal entering into the device is shown by means of arrow CW. The input signal CW is modulated in the modulation section 21 and next amplified by the amplifying section 22. The modulated and amplified signal is then emitted from the device as shown by means of arrow MS.

However in order to reduce the interaction between GCSOA and modulating section of an photonic integrated circuit, the device 20 comprises a filter section 23 located between the modulating section 21 and the amplifying section 22. The amplification spectrum of the GCSOA is preferably selected such that it may provide gain for the modulated wavelengths to be output from the device. Furthermore, the lasing or clamping wavelength of the GCSOA is selected to be out of the operating (and amplified) spectrum of the modulation source. The spectral difference between the clamping wavelength and the wavelengths to be emitted (operating wavelengths) may depend on the actual working band and in the case of C or L band it may preferably be above for example 50nm. For example for an operating wavelength of 1530nm (C band), the clamping wavelength may be chosen in the range of about or less than 1480 nm for shorter wavelength bands. The relation between clamping wavelength and working wavelength may depend on the amplification spectrum width of InP-SOAs which at the present state of the art are typically about 100nm (*i.e.* +50 and -50 from the center). However, it is envisaged to reach larger amplification spectrum widths, for example up to 200nm, in the future.

The filter section 23 is selected so as to provide efficient absorption of the clamping wavelength. Due to the spectral difference between the clamping wavelength and output modulated wavelengths, the filter section 23 may be made transparent (*i.e.* low-loss) for the output modulated wavelengths. Advantageously, the filter section 23 may have a diode structure such as an electro-absorption modulator and have electrical contacts for grounding or reverse biasing.

It is known that the electro-absorption wave-guide diodes can provide loss differences of about 30dB or above, between the transparent and the filter spectral regions thereof.

Therefore, the filter section 23 provides an optical isolation, or optical filtering, of the returning clamping wavelength and protects the active modulation source from blinding or other perturbations (locking, remodulation, etc).

The output modulated wavelength then passes through the filter section 23 and is next amplified by the GCSOA amplifying section 22.

One example for providing such filter function is to set a relatively small part of the modulating section 21 at a constant reverse bias voltage.

The effect of the reverse bias voltage is to shift the material absorption edge to shorter wavelength by a physical effect such as for example Pockels, Kerr or (Quantum Confined) Stark effects acting when strong electrical field is applied to the material. The electrical field in a p-n junction can be applied only under reverse bias conditions. For example, current injection under forward bias would not help as the material is less absorbing or event amplifying in such condition. The value of the voltage is selected according to the requirements for each application so as to absorb the back emitted photons from the GCSOA and evacuate the photo-generated carriers. The absorption edge wavelength of this section is chosen to be in-between the laser emission wavelength and GCSOA emission wavelength. A range of values may be selected, where the selection results from a trade off between the desired absorption of the clamping wavelength and transmission/transparency of the working wavelength.

A device manufactured according to this embodiment may be suitable for example for applications in remote modulators for access networks.

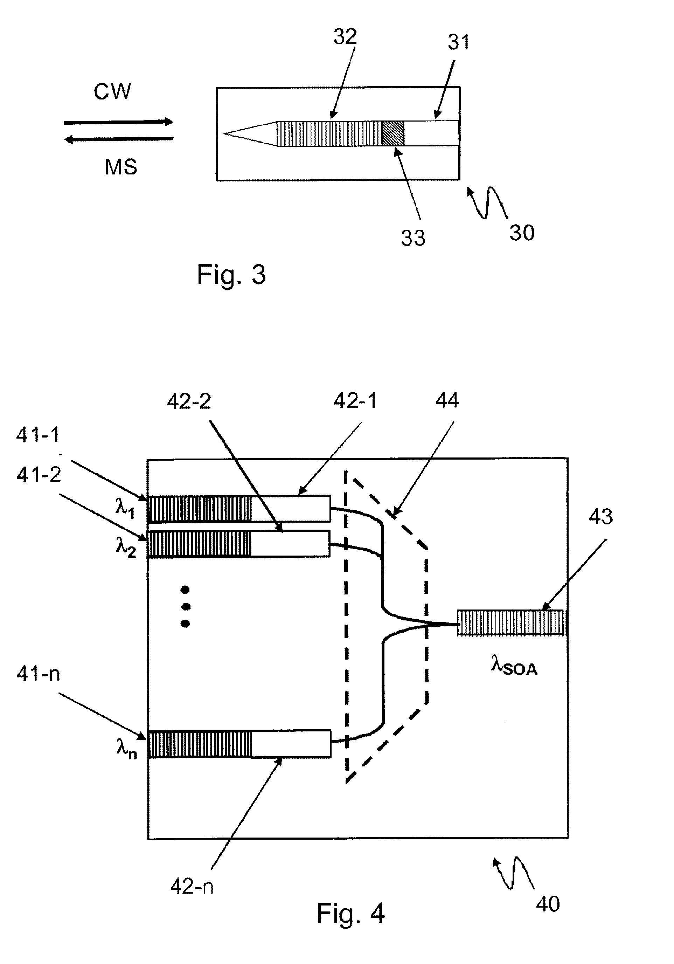

Figure 3 is an exemplary schematic representation of a photonic device 30 according to another embodiment. The device 30 has a modulation section 31 and an amplifying section 32. In this representation, differently from the examples of figures 1 and 2, the device is assumed to be operable in reflection mode such as a reflection electro-absorption modulator R-EAM or reflection Mach-Zehnder interferometer (R-MZ).

The modulation section 31 comprises any known modulation source and the amplifying section 32 is made of a GCSOA. A continuous wave signal entering into the device is shown by means of arrow CW. The input signal CW is modulated in the modulation section 31, reflected back and amplified by the amplifying section 32. The modulated and amplified signal is then emitted from the device as shown by means of arrow MS.

Here again, in a similar manner as discussed in relation to figure 2, in order to reduce the interaction between the GCSOA amplifying section 32 and the modulating section 31 of the photonic integrated circuit, the device 30 comprises a filter section 33 located between the modulating section 31 and the amplifying section 32.

The amplification spectrum of the GCSOA is preferably selected such that it may provide gain for the modulated wavelengths to be output from the device. Furthermore, the clamping wavelength of the GCSOA is selected to be out of the operating (and amplified) spectrum of the modulation source. The spectral difference between the clamping wavelength and the wavelengths to be emitted may depend on the actual working band and in the case of C or L band it may preferably be above for example 50nm, and maybe less, for example for shorter wavelength bands.

The filter section 33 is selected so as to provide efficient absorption of the clamping wavelength. Due to the spectral difference between the clamping wavelength and output modulated wavelengths, the filter section 33 may be made transparent (*i.e.* low-loss) for the output modulated wavelengths. Advantageously, the filter section 33 may have a diode structure such as an electro-absorption modulator and have electrical contacts for grounding or reverse biasing.

As already stated, electro-absorption wave-guide diodes can provide loss differences of about 30dB or above, between the transparent and the absorbing spectral regions thereof.

Therefore, the filter section 33 provides an optical isolation, or optical filtering, of the returning clamping wavelength and protects the active modulation source from blinding or other perturbations (locking, remodulation, etc).

The output modulated wavelength then passes through the filter section 33 and is next amplified by the GCSOA amplifying section 32.

As also mentioned in relation to the embodiment of figure 2, one example for providing a filter function is to set a relatively small part of the modulating section 31 at a constant reverse-bias voltage. The value of the voltage is selected according to the requirements for each application so as to absorb the back emitted photons from the GCSOA and to evacuate the photo-generated carriers. The absorption edge wavelength of this section must be in-between the laser emission wavelength and GCSOA emission wavelength.

A device manufactured according to this embodiment may be suitable for example for applications in WDM applications such as metropolitan networks or access WDM-PON applications.

In order to provide a comparison between the use of a SOA and that of a GCSOA, in relation to the embodiments of figures 2 and 3, it is noted that when an SOA is used in a structure similar to that of figure 2 or figure 3, the modulated signal is amplified by the SOA before exiting the device. However, in this case the output power typically has to be maintained at quite low value (*e.g.* less than about 1 mW) in order to limit the chirp added by the SOA. In contrast, when a GCSOA is used together with a reverse-biased filter section, one may expect to considerably increase the output power (*e.g*. above 10 mW approximately), thus showing substantial improvement in output power.

Figure 4 is an exemplary schematic representation of a photonic device having a structure in accordance with a further embodiment in which a GCSOA may be associated with an integrated wavelength optical filter (such as for example Arrayed Waveguide Grating AWG or wavelength selective couplers). The filter characteristic of such devices may typically provide low loss for output wavelengths and high loss for the clamping wavelength. For example, in the case of a periodic AWG, low-loss windows of wavelengths may correspond to the output wavelength and the clamping wavelength may be placed either in-between or outside of the low-loss windows.

Similarly, the same principle could apply to any wavelength selective filter such as Fabry-Perot, directional coupler, distributed grating, multimode interferometer, multi-layer coating, etc. including the case of unused window guides spatially disconnected from the output wavelength guide path. In such cases, unwanted emission from a multi-guide or multi-path filter (such as for example AWG, directional or grating filters) in fed into a guide which is directed or curved out of the component guide to eventually emit or absorb this light out.

Referring back to figure 4, a photonic device 40 is schematically shown comprising an array of laser sources 41-1,...,41-n, generating wavelengths λ_{1,}...,λₙ. These wavelengths typically have different values, however in certain cases some of these wavelengths may have equal values for example in case where the combiner is not a wavelength channel selecting filter or where the sources are used alternatively.

The laser sources are typically connected to respective modulating sections 42-1,...,42-n in order to modulate the respective incoming wavelengths. The modulated signals are fed into wavelength optical filter 44. In the example shown in figure 4, the wavelength optical filter is an AWG. The output of the wavelength optical filter 44 is fed into a GCSOA 43.

With the aforementioned structure, the lasing wavelength of GCSOA, λ_{SOA} may be selected to be outside the range of the operating wavelength λ1,...,λ1 input in the wavelength optical filter 44. In this manner, the emitters of the modulating sections 42-1,...,42-n are protected from blinding or being perturbed by the GCSOA.

In addition, as already mentioned in relation to figures 2 and 3, using a GCSOA may considerably increase the output power of the multi-wavelength emitter without reducing its transmission properties.

As regards manufacturing of any of the devices described in the aforementioned embodiments, it is to be noted that GCSOA guide integration in a photonic device may be performed by means of many known integration technologies such as butt-joint separate epitaxial growth, quantum-well (QW) intermixing or QW Selective Area Growth. Also, any known guide lateral structure such as deep or shallow ridge, buried stripe heterostructures (p-nBH, SI-BH, etc) may be employed. The technology-adaptive property of GCSOA provides an ample possibility as regards the choice of the technology to be employed which in itself is an important matter to be taken into consideration for a given photonic circuit integration.

The GCSOA may be designed to have a plurality of discrete clamping wavelengths.

The solutions provided herein and described with respect to the various embodiments may be implemented in a simple and quick manner on remote modulators and QPSK EMLs, both components being considered of certain interest for WDM access networks for 40-100Gb/s network applications. The low-cost potential of such integrated devices may offer competitive advantage for equipment requiring low-cost electro-optical interfaces.

The various embodiments of the present invention may be combined as long as such combination is compatible and/or complimentary. For example, if needed, the use of wavelength optical filter, as described in the embodiment of figure 4, may be combined with the use of a filter section such as the one described in relation to figure 2 or figure 3. This may be the case for example where a high rejection clamping wavelength, of about 30dB or more, is required.

Further it is to be noted that the list of structures corresponding to the claimed means is not exhaustive and that one skilled in the art understands that equivalent structures can be substituted for the recited structure without departing from the scope of the invention.

It is also to be noted that the order of the steps of the method of the invention as described and recited in the corresponding claims is not limited to the order as presented and described and may vary without departing from the scope of the invention.

The proposed solution of GCSOA integration reduces the burden of trade-off between amplifier output power and added chirp. In practice, more power output capabilities are expected (for example about 10dBm) while the chirp is maintained at a low level.

GCSOA chirp-free amplification added to photonic integrated circuits opens a way to new low-cost class of complex functions integrated on the same chip which otherwise would involve prohibitive optical loss.

The solution provided by the various embodiments employing GCSOAs presents also interest for very high speed optical amplification as the chirp constraint for a given transmission distance increases with the bit rate. Namely, the integration of GCSOA with 2x50GB QPSK sources should give stand-alone practical components having optical output above OdBm.

Moreover, the amplification spectrum of a GCSOA is not limited to C and L band as it is the case of fiber amplifiers (EDFA). In the case of integration on InP substrate these devices can amplify in the spectrum ranging from 1 µm to 1.7µm. This property is particularly useful for access network wavelengths (*e.g*. 1.3µm and 1.49µm or 1.59 µm) and Coarse WDM devices.

## Claims

1. A photonic integrated circuit device comprising a gain-clamped semiconductor optical amplifier, GCSOA, having at least one clamping wavelength and at least one data modulation section having an operating wavelength, wherein the photonic integrated circuit device further comprises an optical filter section provided between the GCSOA and the data modulation section and configured for filtering a clamping wavelength generated by the GCSOA.

2. The device of claim 1, wherein the optical filter section comprises a part of the data modulation section biased under a reverse-bias voltage.

3. The device of claim 1, wherein the optical filter section comprises a wavelength optical filter.

4. The device of claims 1, wherein the optical filter section comprises a part of the data modulation section biased under a reverse-bias voltage and a wavelength optical filter.

5. The device of claim 3, wherein the wavelength optical filter is an arrayed waveguide grating or a wavelength selective coupler or a wavelength selective filter.

6. The device of any one of the previous claims, wherein the photonic integrated circuit device is operable in emission mode.

7. The device of any one of the previous claims 1 to 5, wherein the photonic integrated circuit device is operable in reflection mode.

8. A method of amplifying an optical signal having an operating wavelength, wherein the operating wavelength is modulated by a data modulation section and amplified by a gain-clamped semiconductor optical amplifier, GCSOA, the data modulation section and the GCSOA being integrated into a photonic integrated circuit device, the method further comprising:
- filtering, by an optical filter section, a clamping wavelength generated by the GCSOA.

9. The method of claim 8 wherein the clamping wavelength of the GCSOA is selected to be out of the operating spectrum of the data modulation section.

10. The method of claim 8 or claim 9, wherein the spectral difference between the clamping wavelength and the wavelengths to be emitted in the case of C or L band is above about 50nm.

11. An optical network element comprising the photonic integrated circuit device of any one of claims 1 to 7.

12. An access network comprising the network element of claim 11.
